Europäisches Patentamt

European Patent Office

Office européen des brevets

(11) Publication number: **0 178 067**
**A1**

# EUROPEAN PATENT APPLICATION

(21) Application number: **85306274.3**

(22) Date of filing: **04.09.85**

(51) Int. Cl.⁴: **G 01 R 21/00**

(30) Priority: **11.09.84 US 849397**

(43) Date of publication of application: **16.04.86**
**Bulletin 86/16**

(84) Designated Contracting States: **CH DE FR GB LI**

(71) Applicant: **WESTINGHOUSE ELECTRIC CORPORATION, Westinghouse Building Gateway Center, Pittsburgh Pennsylvania 15235 (US)**

(72) Inventor: **Munday, Mark Logan, 4032 Camelot Drive, Apt. 3B, Raleigh North Carolina (US)**

(74) Representative: **van Berlyn, Ronald Gilbert et al, 23, Centre Heights, London, NW3 6JG (GB)**

(54) **Watthour meter with demand responsive load control capability.**

(57) A watthour meter is provided with the ability to maintain a clock and calendar. One or more demand threshold values (16) are defined and associated with periods of electrical demand. The demand meter also defines (14); periods of time that represent demand intervals and, during each demand interval, electrical energy consumption pulses (62) are accumulated (63) in order to represent the electrical consumption during the demand interval period. The magnitude of electrical consumption that takes place during each demand interval is compared (80) to one (78) of the plurality (76) of demand thresholds in order to determine if the demand threshold for the current period of time has been exceeded. If it is determined that the demand threshold has been exceeded, the demand meter of the present invention outputs a signal to a load shed relay (32); in order to shed a preselected nonessential electrical load (44) so that the electrical energy demand of the consumer is reduced.

1

## WATTHOUR METER WITH DEMAND RESPONSIVE
## LOAD CONTROL CAPABILITY

The present invention relates generally to a watthour meter and, more particularly, to a demand meter which has the capability to perform load control functions based on the measured power consumption of an individual electrical consumer.

Electrical utilities have, for many years, measured the electrical energy consumption of its customers by the use of kilowatt hour meters that are disposed at each of the consumer's locations. A basic watthour meter measures and accumulates the total electrical energy consumption during a preselected period of time. The electric utility, at the end of each billing period, typically determines the electrical energy consumed, multiplies it by the billing rate (cost per kilowatt hour) and bills the consumer accordingly.

In recent years, some electrical utilities have installed time-of-use meters which are capable of discriminating between electrical energy consumed during certain periods and electrical energy consumed during other periods. Discrimination between the time periods of electrical energy use is important to electric utilities since every electric utility maintains a basic generation capacity and, during times of peak energy usage, an electric utility may have to utilize extra generating plants which possibly use more expensive fuels or, alternatively, purchase electric energy from other utilities. When time-of-use meters are used, different periods of time are billed at different rates, according to a predetermined schedule. For example, during periods which have been historically determined to exhibit peak demand, the billing rate may be higher in order to discourage electrical consumption during that time period. During periods of time when the electrical utility knows that, historically, demand is low, billing rates may be reduced in order to encourage consumers to utilize electrical energy during those times. This type of multiple rate structure has at least two beneficial effects for the electric utility. First, by charging higher rates during peak periods, the electric utility increases its income from those consumers who necessitate its requirement for higher power output capability. Also, by charging higher rates during peak periods and lower rates during periods of load demand, the electric utility provides an incentive for consumers to adjust their power consumption in such a way that the electric utilities overall load experiences a leveling effect.

In order to function properly, a time-of-use meter must be provided with a time keeping capability. In a typical application, a time-of-use meter is provided with a microprocessor that has the capability of maintaining a clock and a calendar. The microprocessor is provided with an input signal, such as a 60 Hz. pulse stream, which enables it to keep accurate time. Since the time-of-use meter has the capability of keeping time of day, it can easily be configured to maintain a calendar that includes day of the week, day of the year and season of the year along with the ability to recognize the occurrence of leap years. This calendar capability is advantageous for the time-of-use meter when different billing rates are assigned to week days, weekends, holidays and different seasons.

Electric utilities have also utilized demand meters which recognize and store the highest energy demand, or peak demand, of the consumer during a preselected period of time, such as a billing period. When a demand meter is used, the consumer is billed at a rate which is a function of both the total kilowatt hours used during the billing period and the consumer's highest peak demand. This enables the electric utility to raise the cost to the consumer based on each particular consumer's contribution to the overall power requirements for the utility.

Many electric utilities are now utilizing load management terminals which provide the capability of shedding loads during periods of high electrical energy consumption. In typical applications, these nonessential electrical loads are shed in order to reduce power consumption during peak periods. The types of loads which are shed during these periods are predetermined nonessential appliances, such as water heaters and air conditioners. When load management terminals are used, various load shedding techniques can be employed.

In one particular method of load management, the electric utility measures its power output at a centralized location. When the combined electrical consumption of its customers reach a predetermined level, the electric utility would cause signals to be output to individual load management terminals which are each located at a customer's site. This command would cause the load management terminals to shed a portion of its load. For example, if an electric utility determines that its power output is approaching its maximum capability, signals may be output to the load management terminals in a specific region to automatically turn off their associated water heaters. If this action proves to be insufficient to adequately reduce the utility's power output, the load management terminals can be sent a subsequent signal to immediately shed their associated air conditioning systems. In this way, the electric utility can reduce the probability that their customers will exceed the power capabilities of the utility. This type of automated distribution system has obvious disadvantages. For example, a relatively sophisticated communication system is required in order to enable the utility, from a central location, to reliably transmit signals to each of its load management terminals which are located at the individual residences of its consumers. The implementation of such an automated distribution system can be expensive to install and maintain.

Another load management technique that can be used by electric utilities is the inclusion of a timing device in each consumer's residence. The timing device can then be set to shed certain loads at predetermined times of the day. Although this technique eliminates the requirement for sophisticated communication devices, it requires the electric utility to be able to accurately predict future times of peak electrical energy demand. Otherwise, the consumers' loads will be shed at times when the power output of the utility, in reality, is not at a peak demand level. This results in added inconvenience for the consumers with no direct benefit for the electric utility. This technique therefore requires the electric utility to be able to accurately predict future periods of peak demand based on historical experience.

The chief object of the present invention is to provide a watthour, demand responsive meter which enables each customer consumer of electrical energy to be treated uniquely by basing the load management system on an electric utility's overall power demand profile which is determined by historical data.

With this object in view, the invention resides in a watthour meter with demand responsive load control capability, comprising: first means for measuring electrical energy consumption; means for providing a series of pulses, each of said pulses being representative of a preselected quantity of said electrical energy consumption; a timer configured to provide a series of timing pulses; second means for measuring a demand interval of time, said second measuring means being cooperatively associated with said timer; means for determining the quantity of said electrical energy consumption that is consumed during said demand interval, said determining means being cooperatively associated with said providing means; first means for defining a first demand threshold value; means for comparing said determined quantity of said electrical energy consumption that is consumed during said demand interval to said first demand threshold value, said comparing means being configured to provide a signal when said first demand threshold value is exceeded by said determined quantity of said electrical energy consumption that is consumed during said demand interval; and means for operating a relay when said signal is provided by said comparing means.

The invention will become more readily apparent from the following exemplary description taken in conjunction with the accompanying drawings, in which:

Figure 1 shows an electrical functional block diagram of the demand meter made in accordance with the present invention;

Fig. 2 illustrates an exemplary power demand profile of a typical electric utility;

Figs. 3A and 3B illustrate an exemplary consumer's energy consumption and interval demands during a plurality of demand intervals;

Fig. 4 shows a block diagram that illustrates the interrelationship between the various components of the present invention; and

Fig. 5 is a flow chart of a portion of a computer program that compares interval demands to demand threshold levels.

The present disclosure reveals that it is advantageous to have a watthour meter that employs the advantages of a demand meter, a time-of-use meter and a load management terminal. This type of device permits the measurement of each consumer's individual demand and sheds the consumer's nonessential loads when a preselected demand threshold is exceeded. Furthermore, by having a timing means that is typically used in a time-of-use meter, this type of demand meter could implement a variety of different threshold levels, depending on the time of day or day of the week. With these capabilities, the demand meter could be set to shed the consumer's load at preselected times only if that particular consumer is exceeding the preselected demand threshold level. Since this type of demand meter has both clock and calendar function capabilities, a plurality of demand thresholds can be used with each of the demand threshold values being assigned to a different time of day or day of the week.

A significant advantage of this type of demand meter is that not all consumers have to be treated identically. For example, a consumer who is using a very small amount of electrical energy need not be subjected to the inconvenience of a load shedding operation, even during peak demand periods for the utility. In comparison, an automated distribution system would typically send commands to the load management terminals to order a load shedding operation regardless of the level of energy being consumed by each of the individual residences. Consumers with both high and low energy consumption during the peak period would be treated identically. In comparison to the timer method described above, this type of demand meter would be advantageous because it could implement a complex schedule of billing rates rather than being limited to merely turning off nonessential appliances at a specific time of the day.

By using this type of demand meter, an electric utility can determine its periods of peak, mid-peak and base level demands as a function of the time of day and day of the week, including a holiday schedule. Each demand meter could then be pre-programmed with the beginnings and endings of these three types of time periods. Each of these three time periods (e.g., peak, mid-peak and base level) could be assigned a unique demand threshold level. The demand meter could then determine its associated consumer's demand level, determine the applicable demand threshold, compare these two values and then determine whether or not that particular consumer's nonessential loads should be shed. If the consumer is utilizing a low level of energy consumption, even during a peak demand period for the utility, its load would not have to be shed. On the other hand, if a consumer is using an extremely high level of energy consumption, even during a period of low peak demand for the utility, some of its nonessential load could be shed. A wide variety of load shedding algorithms could be employed.

This type of demand meter could also be advantageous for the electrical consumer. For example, since electrical utilities sometimes employ higher billing rates during peak demand periods, the consumer may wish to intentionally limit electrical energy consumption during these peak periods in order to reduce overall energy costs during the billing period. If the demand meter is configured to shed some of the consumer's load when that particular consumer's demand reaches a preselected threshold during periods of peak demand for the utility, a significant reduction in the overall electrical cost of the consumer will be achieved since the load shedding would occur during times when electricity is most expensive.

An electrical watthour meter that is cooperatively associated with a means for providing a series of pulses is utilized herein with each of the pulses being representative of a preselected quantity of electrical energy consumption. Various types of pulse initiators are known to those skilled in the art. U.S. Patent No. 4,034,292, which issued to McClelland on July 5, 1977 discloses an opto-electronic pulse initiator for producing meter data pulses from a meter having a rotating movement. A solid state pulse initiating circuit is utilized and includes low power digital integrated circuit elements including a clocked bistable logic circuit. U.S. Patent No. 3,878,391, which issued to McClelland et al. on April 15, 1975, discloses a radiometric pulse initiator for three wire remote meter telemetry systems including interchangeable

8    0178067

reflective pattern drums provided with alternative pre-selectable numbers of reflecting segments for generating a desired pulse rate in response to a predetermined amount of rotation of a watthour meter movement. The present configuration can utilize any one of a number of alternative types of pulse initiators. In a watthour meter made in accordance with the teachings herein, the primary function of the pulse initiator is to provide a stream of pulses in which each of the pulses represents a predetermined quantity of electrical energy consumption.

A timer is incorporated along with a means for measuring a demand interval of time. The timer can be any device that is capable of producing a constant stream of timing pulses of a known frequency. For example, a 60 Hz. signal can readily be used to provide the timing signal. It is well known to those skilled in the art that such a signal can be utilized to provide a clock device. The demand intervals are measured lengths of time during which electrical energy consumption is measured by accumulating the pulses from the pulse initiator. In a typical application of this arrangement, the demand interval would be approximately 15 minutes. However, it should be understood that alternative length of time can easily be accommodated. The demand interval is provided by essentially counting pulses from the timer until the predetermined period of time has elapsed. During each one of a successive plurality of demand intervals, the energy consumption pulses are accumulated. The accumulation of these pulses represents the electrical energy demand of the consumer at whose residence the demand meter is located. At the end of each demand interval, that particular interval's demand is compared to particular one of a plurality of demand threshold levels. Demand threshold levels represent preselected magnitudes of electrical energy consumption during a demand interval. Three unique demand threshold levels are used for purposes of this description.

Electric utilities typically divide time into three basic categories: peak periods, mid-peak periods and off-peak periods. Occasionally, those skilled in the art refer to the mid-peak periods as shoulder periods and also refer to the off-peak period as the base rate. Regardless of the specific terminology, these three different periods represent three predetermined levels of power consumption for the electric utility. The timing of these three types of demand levels can be predicted for a particular utility by reference to that utility's historical experience.

Since this type of demand meter has clocking capability, it can maintain a clock and calendar within it. Using the clock and calendar capabilities, the different demand threshold levels can be exchanged at preselected times. Therefore, the demand meter can be pre-programmed to choose different demand thresholds at different times of the day or days of the week based on the predicted overall demand profile of the electric utility.

When the demand meter recognizes the fact that an interval demand exceeds the predetermined demand threshold level for that period of time, a signal is provided that indicates this fact. When this signal is present, various actions can be taken by the demand meter. The action taken as described herein is the activation of a normally closed contact which is connected in series with a nonessential electrical load in the consumer's residence. For example, this normally closed contact can be cooperatively associated with an electric water heater or air conditioning system. Simultaneous activation of an indicator while shedding the nonessential load is also informative. The indicator can be a light or other appropriate signalling device. This would indicate to the consumer that the load has been shed. If a subsequent demand interval consumes less energy than its associated demand threshold level, the contact would be deenergized and the nonessential electrical load would again be provided with power.

can be configured to immediately shed its load during any demand interval that exceeded the demand threshold level. Alternatively, the load shedding procedure can be delayed for one demand interval subsequent to the recognition that the demand threshold has been exceeded and this condition is maintained until there is a demand interval during which the demand threshold is not exceeded.

The demand meter is provided with a microprocessor that is used to accumulate the energy consumption pulses and compare the interval demand for each of the demand intervals with its associated demand threshold level.

A plurality of demand intervals and threshold levels can be stored in random access memory (RAM). The microprocessor is also provided with the capability of activating and deactivating a relay for performing the load shedding procedure.

The demand meter of this disclosure enables each consumer to be treated individually by providing a load management system that is based on an electric utility's overall power demand profile which is determined by historical data. The demand meter bases its load shedding decisions on both the peak power demand periods experienced by the electrical utility and the actual energy consumption of the individual electrical consumers.

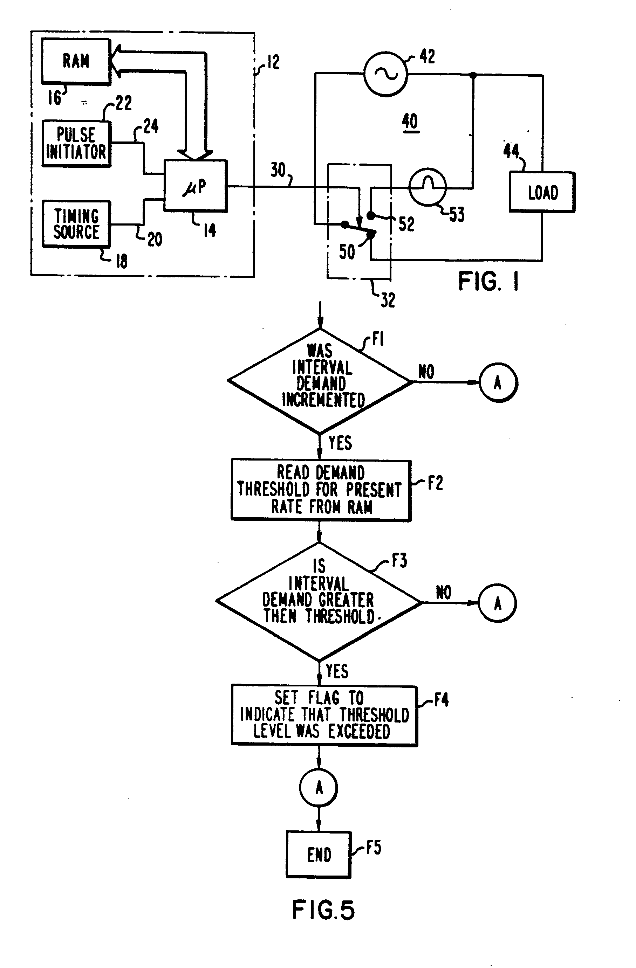

Fig. 1 illustrates a functional block diagram of the present invention connected in electrical communication with an electrical load. The demand meter 12 comprises a microprocessor 14 which is connected in cooperative association with a random access memory (RAM) device 16. The microprocessor 14, in a preferred embodiment of the present invention, is type MK38P70/02 or 3870/40 which is available from the Mostek Corporation. The RAM 16 is type 6514 or 6561 which is available from the Harris Corporation.

The microprocessor 14 is configured to maintain a clock and calendar system within it. A timing source 18 provides a series of timing pulses, on line 20, to the microprocessor 14. These timing pulses, which have a predetermined constant frequency, are used as the basic unit of time by the microprocessor 14 to maintain both clock and calendar variables. The timing source 18 can be any one of a number of various sources known to those skilled in the art. For example, a 60 Hz. signal from the power line can be used to provide the timing pulses. The microprocessor 14 receives the series of timing pulses, on line 20, and counts the pulses until one second elapses. It then counts the seconds until a minute elapses and maintains this procedure in order to monitor the passage of time in seconds, minutes, hours, days, weeks, months, and years. Once initialized with the year from leap year, date and time, the microprocessor 14 can continually maintain a set of calendar and clock variables that enables it to always be aware of the accurate time and date.

The microprocessor 14 is also operatively connected to a pulse initiator 22 that provides a series of pulses, on line 24, to the microprocessor 14. The pulse initiator 22 can be any one of a variety of known pulse initiators such as those discussed above. Each pulse that is sent, on line 24, to the microprocessor represents a predetermined quantity of electrical energy consumption. Each time a pulse is received on line 24, the microprocessor accumulates that pulse along with proceeding pulses in order to determine the electrical consumption during any preselected period of time.

The RAM 16 provides a microprocessor 14 with a means for storing various data registers during periods of time when the microprocessor 14 is not actively manipulating them. During operation, the microprocessor 14 would receive timing pulses on line 20 and energy consumption pulses on line 24 and, through various simple algorithms, accumulate the energy consumption pulses as a function of time. When data registers require updating, the microprocessor 14 reads the current value of the registers from the RAM 16 into its active memory storage and updates this data based on the pulses received on lines 20 and 24. After the data registers are updated, they are again stored in the RAM 16.

The microprocessor 14, in association with the RAM 16, defines periods of time, referred to herein as demand intervals, during which separate accumulations of energy pulses are maintained. During each demand interval, the microprocessor 14 accumulates the sequential pulses received on line 24 and, at the end of each demand interval, compares the interval demand to one or more demand threshold values. Each demand threshold value has a predetermined magnitude that is determined as a function of either time of day or day of the week. The actual magnitudes of these demand thresholds is determined from historical data for the particular electric utility using the demand meter 12. Typically, the electric utility would define three different periods of time: peak periods, mid-peak periods and base rate periods. Each of these types of time period would be associated with a different one of three demand threshold levels. For example, during times of the day when the electric utility anticipates peak power demand by its customers, a specific demand threshold which is associated with peak periods would be used.

At the end of each demand interval, the microprocessor 14 compares the current interval demand with the demand threshold value that is currently being used. If the current interval demand is less than the demand threshold value, no action is taken and the microprocessor 14 continues to accumulate energy consumption pulses, on line 24, for the next demand interval. However, if the interval demand exceeds the demand threshold value, an appropriate signal is set to indicate this occurrence.

Based on one of several simple algorithms, the microprocessor 14 transmits a signal on line 30 when it determines that a demand threshold level has been exceeded. Line 30 operatively connects the microprocessor 14 with a relay 32. In a preferred embodiment of the present invention, the relay 32 has a single-pole double-throw (SPDT) contact which is capable of performing a break-before-make function. This type of contact is commonly referred to as a Form C contact. In a typical application of the present invention, another relay can be implemented for the purpose of handling higher currents that is fed from the form C contact. In fact, the present invention could be easily implemented in situations where no automated load control is used.

A simplified residence electrical system 40 is shown in Fig. 1 with a power source 42 and an electrical load 44. The power source 42, in a typical application of the present invention, is a normal home wiring system which is capable of providing either 120 volt AC or 240 volt AC power to the electrical load 44. A normally closed contact 50 is connected electrically in series between the power source 42 and the load 44. When activated by a signal from the microprocessor 14, the normally closed contact 50 is opened and the electrical load 44 is disconnected from the power source 42. This operation is referred to as load shedding. It should be understood that, in a typical application of the present invention, the electrical load 44 is a nonessential load such as a water heater or air conditioner. These types of nonessential loads are chosen so that the consumer is not significantly inconvenienced when they are shed during periods of peak demand.

Also shown in Fig. 1 is a normally open contact 52 which is connected electrically in series between the power source 42 and a signal device 56. Although not a requirement of the present invention, the connection of the signal device 52 in series with the normally open contact 52 provides a signal for the consumer that indicates the shedding of the load 44. The signal device 52 can be a lamp or an audio alert device. The function of the signal device 52 is to alert the consumer that, due to the recognition of an interval demand that exceeds the demand threshold level, the nonessential electrical load 44 has been shed. This enables the consumer to take appropriate action, if desired, to reduce the consumption to a level that will again connect the load 44 to the power source 42.

The normally closed contact 50 would remain open, following a demand interval during which the interval demand exceeded the demand threshold value, until a subsequent demand interval indicated that its interval demand is below the current demand threshold value. Therefore, if demand intervals of 15 minutes are utilized by the demand meter 12, the electrical load 44 would remain disconnected for periods of 15 minutes following each occurrence when the interval demand exceeded the current demand threshold value.

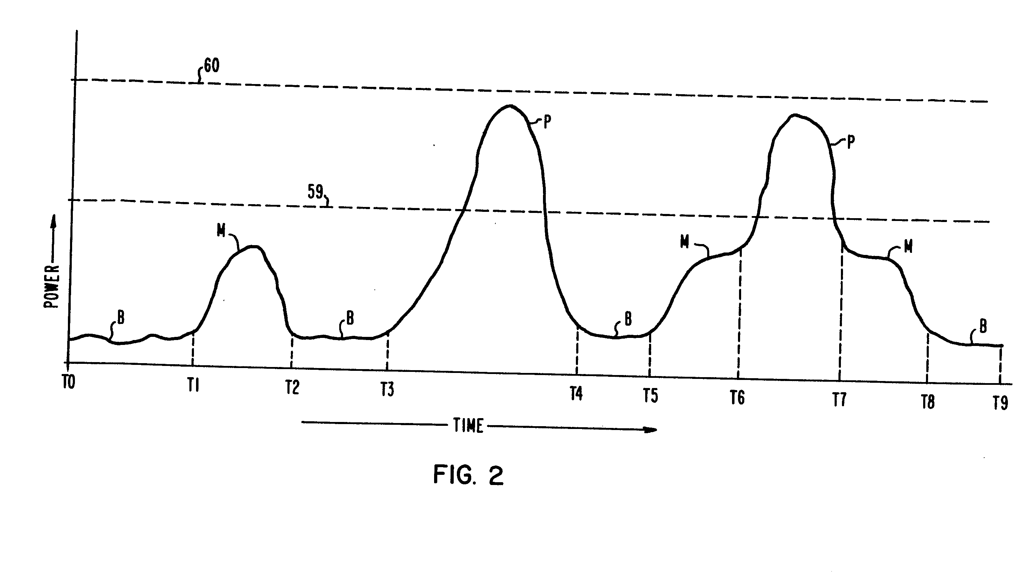

In order to describe the present invention in greater detail, the exemplary power demand profile of an electric utility, shown in Fig. 2, will be used. An electric utility is able, using historical information, to determine its own particular power demand profile. The level of power demand for an electric utility typically varies as a function of the hours of a day and the days of the week. Base rate periods B, mid-point peak periods M or peak periods P can be determined from historical information. Fig. 2 illustrates a period of time over which these various levels of power demand occur. It should be understood that Fig. 2 represents an exemplary historical profile for a particular hypothetical electric utility and does not necessarily represent the actual power demand during the illustrated periods of time.

As can be seen in Fig. 2, the historical profile of this exemplary electric utility indicates that a base rate demand level is expected between time periods T0-T1, T2-T3, T4-T5 and T8-T9. Fig. 2 also illustrates that, based on historical experience, this particular hypothetical electric utility expects mid-peak demand levels during periods T1-T2, T5-T6 and T7-T8. As shown in Fig. 2, periods T3-T4 and T6-T7 indicate that the particular electric utility anticipates peak demand levels during those times. Dashed line 59 represents a hypothetical demand level where expensive fuel generation plants may be required by the electric utility in order to provide the demanded electrical energy. Dashed line 60 represents a demand level that approaches the total power capability of this particular electric utility. If the electrical energy demand exceeds level 59, auxiliary generating facilities may have to be initialized and if the demand exceeds level 60, the electric utility would be expected to provide power beyond its own capabilities. Therefore, electrical power would have to be purchased from other utilities or power shortages would occur. It should be understood that, with respect to the demand profile illustrated in Fig. 2, a single day would typically appear as the portion of Fig. 2 between time periods T4 and T9.

Since the peak demand periods for an electric utility determine its power generation requirements, it is beneficial to attempt to level the demand profile. This would reduce the magnitude of the peak periods by providing incentives for the utility's consumers to reduce consumption during these periods and, if possible, shift the demand to periods of time when lower demands are expected. One method of providing these incentives is to utilize multi-rate billing schedules. For example, during periods when peak demand is expected (e.g., periods T3-T4 and T6-T7), a higher rate can be charged, for each unit of power consumed, than during periods when peak demand is not expected. If an electric utility is able to define three levels of expected demand, such as those indicated in Fig. 2, three unique billing rates can be employed.

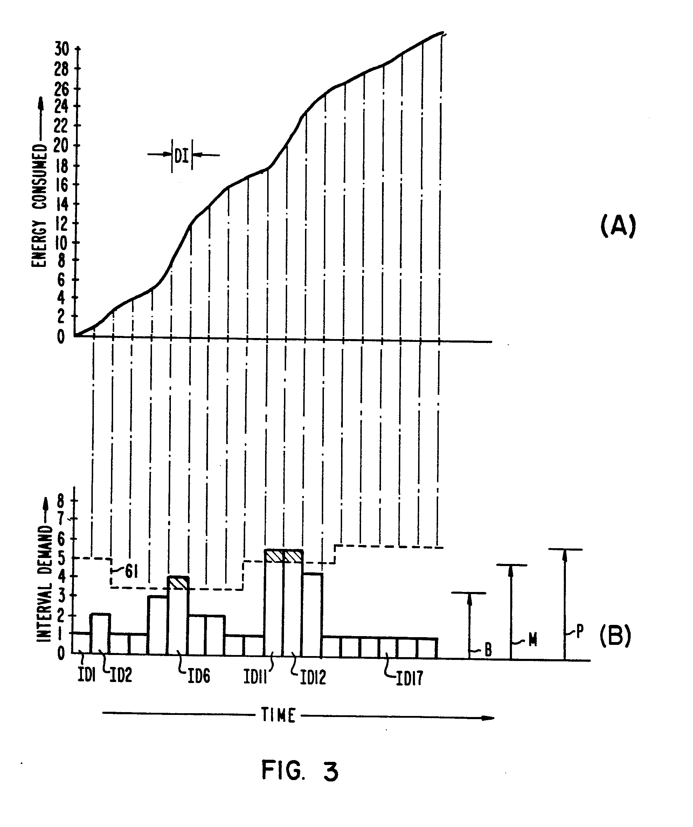

To further describe the present invention in relation to an individual consumer's energy consumption, an exemplary consumption profile is illustrated in Fig. 3A. Starting with the beginning of a billing period, the exemplary consumer is shown as consuming electrical energy throughout nineteen sequential demand intervals DI. Since Fig. 3A shows the accumulation of consumed energy, its curve continues to rise throughout the time period illustrated. However, it should be apparent that this consumer's rate of consumption during the illustrated period varies significantly. Fig. 3B shows the individual interval demands that were measured during each of the demand intervals. Also shown in Fig. 3B is a dashed line 61 that represents the changing demand threshold values that were determined by the electric utility and pre-programmed into the demand meter of the consumer. It should be understood that, in both Fig. 3A and Fig. 3B, the numeric representations for energy consumed in interval demand are chosen for illustrative purposes only. The interval demand profile of Fig. 3B illustrates the actual energy that was consumed in each of the nineteen illustrated demand intervals. As can be seen, one unit of energy was consumed during the first, third, fourth and ninth demand intervals, among others, while two units of energy were consumed during the second, seventh, eighth and thirteenth demand intervals. The demand threshold line 61 illustrates the changes of demand threshold from a base rate demand threshold of 3.5 units to a mid-peak demand threshold of 5 units and a peak demand threshold of 6 units. It should be understood that these values are arbitrary and have been chosen only for illustrative purposes. And it should also be understood that normally an electric utility is less concerned about the electrical power consumed during the off-peak or mid-peak periods. These thresholds are generally larger than the peak period threshold.

Some of the advantages of the present invention can be seen in Fig. 3B. For example, from the third demand interval to the ninth demand interval, a peak demand threshold value is used. However, since this particular consumer's power consumption during the third, fourth, fifth, seventh, eighth and ninth demand intervals is below the demand threshold value, this consumer's electrical consumption is not affected. However, during the sixth demand interval, an interval demand ID6 of four units is accumulated and recognized as exceeding the demand threshold level of 3.5. At the end of the sixth demand interval, the nonessential electrical loads of this consumer's residence would be shed by the demand meter. Similarly, the eleventh and twelfth demand intervals exhibited interval demands that exceeded a mid-peak demand threshold value and appropriate load shedding would be indicated.

It should be apparent, as illustrated in Fig. 3B, that the actual occurrence of load shedding for a particular consumer is a function of not only the electric utility's demand profile, but also the particular consumer's actual energy consumption. During periods that are expected to exhibit high power demands for the electric utility, the individual consumer can avoid load shedding operations by conserving electrical energy in other ways. In other words, the individual consumer's load shedding is a function of both the consumer's energy consumption for each demand interval and the demand threshold chosen by the electric utility based on historical demand data.

Referring again to Fig. 3B, it can be seen that the present invention can also provide a significant economical advantage to the individual consumer. When an electric utility incorporates a multi-rate billing schedule, the rate per kilowatt hour during periods of peak demand is set at a higher value than during other periods. Therefore, if a consumer utilizes a high level of energy during these periods of expected peak demand, the consumer's electric bill will be increased substantially. However, if the consumer's electrical consumption is reduced by the load shedding procedure described above, the overall electrical consumption by the consumer during these peak periods will be reduced with a corresponding reduction in the consumer's electric bill at the end of the billing period.

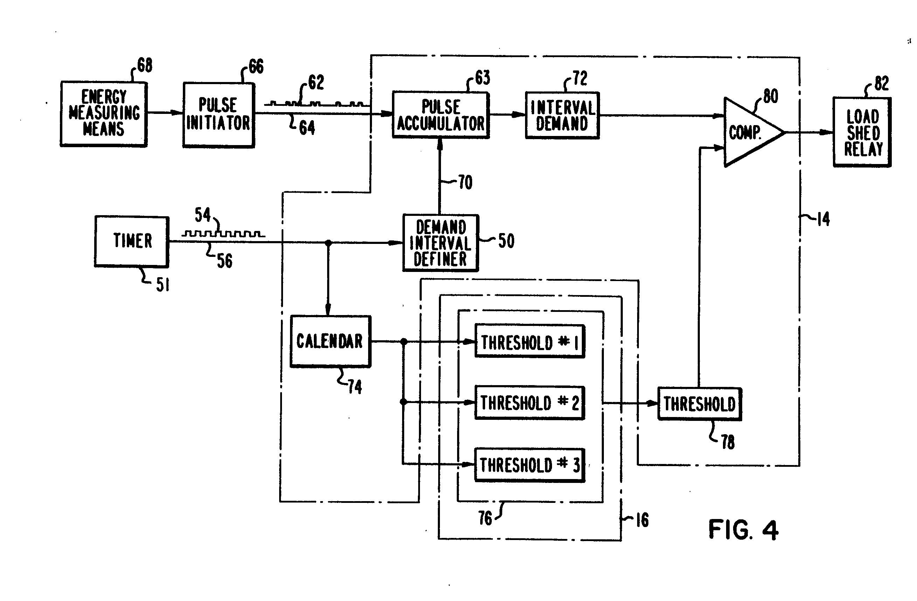

Fig. 4 illustrates a functional block diagram of the present invention. Within the microprocessor 14, there is incorporated a demand interval definer 50 which is

18    0178067

cooperatively associated with a timer 51. The timer 51 is functionally equivalent to the timing source 18 that is illustrated in Fig. 1. The timer 51 is capable of producing a series of timing pulses 54 which are sent, on line 56, to the demand interval definer 50 of the microprocessor 14. The function of the demand interval definer 50 is to count the pulses 54 until a predetermined demand interval of time passes. For example, if the timing pulses 54 have a frequency of 60 Hz. and the demand interval is chosen to be 15 minutes long, the demand interval definer 50 would count 54,000 timing pulses before it determines that a demand interval has passed.

The microprocessor 14 also comprises a pulse accumulator 63 which receives a series of energy consumption pulses 62, on line 64, from a pulse initiator 66. It should be understood that the pulse initiator 66 is functionally identical to the pulse initiator 22 of Fig. 1. Many various types of pulse initiators 66, such as those described above, can be used in conjunction with the present invention. The pulse initiator 66 is cooperatively associated with an energy measuring means 68 which can be any one of various types of watthour meters that are known to those skilled in the art. Each pulse 62 that is received by the pulse accumulator 63 represents a predetermined quantity of energy consumption that is measured by the energy measuring means 68. The pulse accumulator continues to accumulate the pulses 62 until it receives enough pulses to represent one unit of demand. When the pulse accumulator 63 receives this value it adds the value in an interval demand register 72. The value stored in the interval demand register 72 represents a number of pulses that have been accumulated during the present demand interval. The interval demand register will continue to record maximum demand until the demand interval definer sends a signal that signifies the end of the demand interval. At that time the interval demand register is reset to zero.

The microprocessor 14 also comprises a means for maintaining a calendar 74 which is a collection of calendar registers that maintain numbers that represent the year, month, day of the week, day of the year and date. The calendar 74 is functionally dependent on the same timing pulses 54 that are received from the timer 52. The calendar portion of the microprocessor 14 is provided with information that identifies various times of the day and days of the week that represent the beginnings and endings of time periods that are associated with different demand levels. In a typical application of the present invention, three different levels of demand are utilized. These levels of demand include peak demand, mid-point demand and base rate demand.

The three demand thresholds are maintained in a table 76 in RAM 16 and, depending on the current time of the day and day of the week, one of the three thresholds is chosen, read from RAM and stored in the microprocessor for comparison with the most recent interval demand 72. This stored threshold value is indicated by reference numeral 78 in Fig. 4.

With each entry in the interval demand register, the interval demand 72 is compared with the threshold 78 in order to determine if the consumer has exceeded the current demand threshold value. These values are input to a comparator 80 and, if the most recent interval demand 72 exceeds the demand threshold 78, a flag is set and a load shed relay 82 can be activated. As described above, the load shed relay would be operatively connected to a nonessential electrical load in the consumer's residence and activation of the load shed relay 82 would operate to shed that load when it has been determined that the most recent interval demand 72 exceeds the demand threshold 78 that is applicable for that specific period of time. It should be understood that Fig. 4 represents a functional block diagram of the present invention and does not necessarily limit the precise techniques used to perform these functions.    In   a   preferred   embodiment   of   the   present
invention,  the  functions  within  the  microprocessor  14  are
performed by software programs.

Fig. 5 illustrates a flow chart of the program
that  compares  the  current  interval  demand  (reference
numeral 72 in Fig. 4) with the demand threshold (reference
numeral 78 in Fig. 4).   In a preferred embodiment of the
present invention, the logic represented by the flow chart
in Fig.  5 would be incorporated with other timing programs
that maintain the clock and calendar.

As indicated by block Fl in Fig.  5, the program
first determines whether or not the interval demand register has been incremented.  Viewing Figs. 4 and 5 together,
block Fl is used to determine if a new interval demand 72
has  been  calculated.   This  could  occur  in  two  distinct
ways.   First,  a  signal  could  be  sent  from  the  demand
interval definer 50 to the pulse accumulator 63 that the
time period of the current demand interval has ended.  This
would result in a new interval demand 72 being stored.  In
an alternative embodiment of the present invention, however, the program could store a new interval demand 72 when
it is determined that the pulses accumulated by the pulse
accumulator 63 have exceeded a value that represents a
previous high interval demand regardless of whether or not
the  actual  demand  interval  has  ended.   Regardless  of  the
precise technique in obtaining the interval demand 72, the
program illustrated by the flow chart in Fig. 5, as represented  by  block  Fl,  would  respond  to  a  change  in  the
interval demand 72.   If no new interval demand has been
obtained,  the program would end as indicated by block F5.
If  a  new  interval  demand  has  been  obtained,  the  demand
threshold 78 would be determined.  As indicated by block
F2, the demand thresholds 76 would be stored in RAM (reference numeral 16 in Fig. 1).  However, it should be understood  that  this  representation  of  the  present  invention
does not preclude the demand threshold 76 from being stored
in  the  active  memory  storage  of  the  microprocessor  14.

As shown by block F3 in Fig. 5, the interval demand 72 is then compared to the demand threshold 78 which has been determined to be the proper one for this particular time period. If the interval demand is less than the demand threshold, the program ends as indicated by block F5. However, if the interval demand exceeds the demand threshold 78, a flag is set that represents the fact that the threshold has been exceeded. This is represented by block F4 in Fig. 5. This portion of the program then ends, as indicated by block F5.

The flag which is set to indicate that the demand threshold 78 has been exceeded by the interval demand 72 for the current demand interval stores the status of this occurrence. Another portion of the program within the microprocessor 14 monitors this flag and, based on one of several simple algorithms, activates a load shed relay 82. The algorithm can be as simple as merely testing the status of the flag and outputting a signal to the load shed relay if the status represents the fact that the demand threshold 78 has been exceeded. A slightly more complicated algorithm would save the flag until the end of the subsequent demand interval before activating the load shed relay 82. It should be understood that many alternative choices exist for the action to be taken when the microprocessor 14 recognizes that the flag is set.

It should be apparent that the present invention provides a means for defining a plurality of demand threshold values that are a function of the time of day and day of the week. The magnitudes of these demand threshold values are determined from the historical demand profile of the electric utility. The present invention also provides a means for defining a period of time referred to herein as a demand interval. During each demand interval, the present invention accumulates a plurality of pulses that represent the consumption of electric energy. During each demand interval, these energy consumption pulses are accumulated and, at the end of the demand interval, this

0178067

interval demand is compared to one of the plurality of demand thresholds. If the interval demand for the current period exceeds the chosen demand threshold value, a load shed relay is activated in order to shed a nonessential electrical load within the residence period. The present invention permits each electric consumer to be treated individually as a function of that consumer's actual electrical energy consumption during the different periods of demand of the electric utility period.

0178067

This copy with reference numerals inserted, is enclosed in order to assist you in interpreting and/or translating the claims, as required.

23

What we claim is:

1. A watthour meter with demand responsive load control capability, characterized by comprising:

first means [Fig. 1 (22); Fig. 4 (68)] for measuring electrical energy consumption;

means [Fig. 1 (22); Fig. 4 (66)] for providing a series of pulses (62), each of said pulses being representative of a preselected quantity of said electrical energy consumption;

a timer [Fig. 1 (18); Fig. 4 (51)] configured to provide a series of timing pulses (54) and characterized by;

second means [Fig. 1 (14); Fig. 4 (50)] for measuring a demand interval of time, said second measuring means being cooperatively associated with said timer;

means [Fig. 1 (14); Fig. 4 (63)] for determining the quantity of said electrical energy consumption that is consumed during said demand interval, said determining means being cooperatively associated with said providing means;

first means [Figs. 1, 4 (16)] for defining a first demand threshold value [Fig. 4 (78)];

means [Fig. 1 (14); Fig. 4 (80)] for comparing said determined quantity of said electrical energy consumption that is consumed during said demand interval to said first demand threshold value, said comparing means being configured to provide a signal when said first demand threshold value is exceeded by said determined quantity of said electrical energy consumption that is consumed during said demand interval; and

means [Fig. 1 (32); Fig. 4 (82)] for operating a relay when said signal is provided by said comparing means.

2. The watthour meter as claimed in claim 1, further comprising:

calendar means [Fig. 1 (14); Fig. 4 (74)] for identifying preselected periods of time;

second means [Fig. 1 (16); Fig. 4 (76)] for defining a second demand threshold value; and

means [Fig. 5 (F2)] for replacing said first demand threshold value with said second threshold value at a preselected one of said preselected periods of time.

3. The watthour meter as claimed in claim 1 or 2, further comprising:

third means [Fig. 1 (16); Fig. 4 (76)] for defining a third demand threshold value;

means [Fig. 5 (F2)] for replacing said first demand threshold value with said third demand threshold value or another preselected one of said preselected periods of time.

4. The watthour meter as claimed in claim 1, 2 or 3, wherein:

said relay is cooperatively associated with a preselected electrical load [Fig. 1 (44)].

5. The watthour meter as claimed in claim 1 or 4, wherein:

said relay is cooperatively associated with an indicator (53), said indicator being indicative of the status of said signal.

6. The watthour meter of claim 1, wherein said determining means, said first defining means and said comparing means are included in a microprocessor.

FIG. I

FIG.5

FIG. 2

FIG. 3

FIG. 4

European Patent
Office

**EUROPEAN SEARCH REPORT**

Application number

EP 85 30 6274

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | EP-A-0 060 920 (FELTEN & GUILLEAUME ENERGIETECHNIK) * claims 1, 7; pages 1, 2, figure 2 * | 1,4,6 | G 01 R 21/00 |
| A | | 3 | |
| | --- | | |
| Y | GB-A-2 019 138 (ELECTRICITY SUPPLY BOARD) * abstract, figure 1 * | 1,4,6 | |
| A | | 3 | |
| | --- | | |
| Y | WO-A-8 202 954 (GENERAL ELECTRIC CO.) * claims 1, 2, figures 1, 5A, 5B * | 1,4,6 | |
| | | | **TECHNICAL FIELDS SEARCHED (Int. Cl.4)** |
| A | * figure 5A * | 2 | G 01 R 11/00<br>G 01 R 11/36<br>G 01 R 21/00 |
| | ----- | | |

The present search report has been drawn up for all claims

| Place of search | Date of completion of the search | Examiner |
|---|---|---|
| BERLIN | 12-12-1985 | LEMMERICH J |